(19) Europäisches Patentamt
European Patent Office
Office européen des brevets

(11) Publication number: 0 293 247 A1

(12) **EUROPEAN PATENT APPLICATION**

(21) Application number: 88304865.4

(22) Date of filing: 27.05.88

(51) Int. Cl.[4]: C 01 F 7/46
C 01 F 7/36, H 01 L 23/14

(30) Priority: 27.05.87 US 54822

(43) Date of publication of application:
30.11.88 Bulletin 88/48

(84) Designated Contracting States:
DE FR GB IT LU NL

(71) Applicant: E.I. DU PONT DE NEMOURS AND COMPANY
1007 Market Street
Wilmington Delaware 19898 (US)

(72) Inventor: Tebbe, Frederick Nye
501 Gibben Road
Hockessin Delaware 19707 (US)

(74) Representative: Watkins, Arnold Jack et al
European Patent Attorney Frank B. Dehn & Co. Imperial
House 15-19 Kingsway
London WC2B 6UZ (GB)

(54) **Ultra low alpha-particle-emitting aluminum hydroxide and alumina.**

(57) Ultra low alpha(α)-emitting aluminum hydroxide and a process for making it from triethylaluminum; when the latter contains α-radiation-emitting contaminants, the process comprises (i) fractionating substantially unhydrolyzed triethylaluminum into an uncontaminated fraction having an ultra low α-radiation flux and a fraction containing substantially all of the α-radiation-emitting contaminants, (ii) separating the two fractions, and (iii) hydrolyzing the uncontaminated fraction with water having an ultra low α-radiation flux; $Al_2O_3$ prepared from said aluminum hydroxide; and ceramics made from said $Al_2O_3$.

EP 0 293 247 A1

## Description

# ULTRA LOW ALPHA-PARTICLE-EMITTING ALUMINUM HYDROXIDE AND ALUMINA

This invention concerns aluminum hydroxide, alumina and alumina-based ceramics, all characterized by ultra low α-radiation emissions, as well as a process for making the aluminum hydroxide.

The integrated circuit network associated with computer random access memory (RAM) is often packaged in a ceramic material. That is, the network of circuit chips is utilized while supported on a ceramic insulating substrate. Alumina ($Al_2O_3$) is often the material of choice for ceramic applications of this type. Commercially available aluminas are usually found contaminated by traces of α-emitting isotopes of uranium and thorium. Such emissions, when they occur in the environment of RAM circuitry, are a likely source of computer error. Such an error is referred to as a soft error. Soft errors caused by spurious commands from α-emissions are troublesome and their elimination is a top priority in the industry. One way to eliminate the soft error problem is to develop an alumina which is substantially free of α-emitting impurities. See, in this regard, May et al., IEEE Trans. Electron Devices, ED-26, 1, 33(1979), and Morris et al., Mat. Res. Soc. Symp. Proc. Vol. 40, pages 89 to 95, Materials Research Society, 1985.

EPA 116,319 discloses $Al(OH)_3$, $Al_2O_3$ and processes for making them. $Al(OH)_3$ is made by partially hydrolyzing triethylaluminum and distilling the product of this partial hydrolysis step preparatory to a step which consists of complete hydrolysis of the distillate to yield purified $Al(OH)_3$. .

The aluminum hydroxide $Al(OH)_3$, of the instant invention is an ideal precursor for ultra low α-emitting alumina. One method for conversion of $Al(OH)_3$ to $Al_2O_3$ is described in detail by Morris et al., in "Clean-Room and $CO_2$-Laser Processing of Ultra-High-Purity $Al_2O_3$", Defect Properties and Processing of High Technology Nonmetallic Materials, Materials Research Society Proceedings, pages 60 to 67, Mat. Res. Soc., Pittsburgh, PA, 1986.

The present invention provides aluminum hydroxide characterized in that $Al_2O_3$ made from it has an α-radiation flux below about 0.003/cm$^2$-hr. This invention also provides alumina and alumina-based ceramics made from the aluminum hydroxide according to the invention, electronics packages having a ceramic insulating substrate comprising such alumina, random access memory components including such electronics packages and computers having such random access memory components.

Given the ultra low α-emitting aluminum hydroxide of this invention, one skilled in the art will be able to prepare correspondingly pure alumina and alumina-based ceramics.

This invention also concerns a method for making aluminum hydroxide employing refinements in the following process for hydrolyzing contaminated triethylaluminum:

$Al(CH_2CH_3)_3 + 3H_2O \rightarrow Al(OH)_3 + 3C_2H_6$.

Synthesis of ultra low α-emitting $Al(OH)_3$ and alumina depends upon the purity of the precursors from which $Al(OH)_3$ is made. From uncontaminated $Al(Et)_3$, i.e., having α-emissions below the threshold defined hereafter, one can prepare $Al(OH)_3$, $Al_2O_3$ and other alumina-based ceramics of correspondingly low α-particle emissions.

According to a still further feature of the present invention, there is thus provided a method of making aluminum hydroxide according to the invention as hereinbefore defined comprising hydrolyzing triethylaluminum having an ultra low α-radiation flux by contacting it with water having an ultra low α-radiation flux.

It has been found that, in the following method according to the invention, the fractionation step [i.e. step (i)] is effective to lower α-emissions of contaminated $Al(Et)_3$ below the desired threshold. Thus, by the following method according to the invention the $Al(OH)_3$ is prepared from contaminated $Al(Et)_3$ by:

(i) fractionating substantially unhydrolyzed triethylaluminum contaminated by α-radiation-emitting contaminants into a fraction consisting essentially of ultra low α-emitting triethylaluminum and a fraction comprising substantially all the α-emitting contaminants;

(ii) separating the uncontaminated triethylaluminum from the contaminants;

(iii) hydrolyzing the uncontaminated triethylaluminum by contacting it with ultra low α-emitting water. Starting with uncontaminated $Al(Et)_3$, ultra low α-emitting $Al(OH)_3$ can be prepared by hydrolysis step (iii).

By "ultra low α-emitting" is meant that the materials so characterized, e.g., $Al(Et)_3$, $Al(OH)_3$, $Al_2O_3$, and water, have α-radiation fluxes contributing less than 0.003 α-particle/cm$^2$-hr to $Al_2O_3$ made from these materials. The term "contaminated" is employed to characterize such materials having α-radiation fluxes which contribute 0.003 α-particle/cm$^2$-hr, or more, to $Al_2O_3$ derived from them. Preferably, α-radiation fluxes will be below about 0.001 cm$_2$- hr and, most prefrably, about 0.0006 to 0.0007 cm$^2$-hr. It has been found with respect to ultra low α-emitting $Al(OH)_3$ and $Al(Et)_3$ that uranium levels are typically below 0.0007 ppm (0.7 ppb) and thorium levels are below 0.001 ppm (1 ppb). With respect to reactant water, uranium levels are typically below 0.00005 ppm and thorium levels are below 0.0006 ppm. In addition, contemplated water resistivities are typically 10 megohm-cm and may approach 18 megohm-cm.

By "alpha particle", as the term is employed herein, is meant a helium nucleus emitted spontaneously from radioactive elements, both natural and man-made. Its energy is in the range of 4 to 8 MeV, and is dissipated in a very short path. It has the same mass and positive charge as the helium nucleus.

### Calculation of Flux Values

Computation of most preferred flux values is based on $Al(OH)_3$ being converted to $Al_2O_3$ without

introduction of alpha particle emitting elements, and alpha particle flux being linear, with U and Th concentrations in $Al_2O_3$ between 1 ppm and 0.7 ppb and 1 ppm and 1 ppb, respectively. The $\alpha$-particle flux of alumina (density 3.98) containing 1 ppm of U is $0.4/cm^2$-hr and that of alumina containing 1 ppm of Th is $0.12/cm^2$-hr.

Aluminum hydroxide is converted to alumina according to the equation:

$$2Al(OH)_3 \longrightarrow Al_2O_3 + 3H_2O$$
$$2(MW\ 78) \qquad MW\ 102$$

$^{238}U$ was not found in $Al(OH)_3$ made by the method of this invention at a detection limit of 0.7 ppb; Th was not found in the $Al(OH)_3$ at a detection limit 1 ppb. Because of water loss (weight loss) in going from aluminum hydroxide to alumina, computation shows that the uranium level in alumina is below 0.001 ppm and the thorium level is below 0.0015 ppm. The alpha particle flux expected from $^{238}U$ in $Al_2O_3$ derived from this $Al(OH)_3$ is

$\alpha/cm^2$-hr $<0.7 \times (2)\ (78)/102 \times 0.4 \times 10^{-3} = <0.0004$ (from $^{238}U$).

The flux from Th is:

$\alpha/cm^2$-hr $<1 \times (2)\ (78)/102 \times 0.12 \times 10^{-3} = <0.0002$ (from Th). The estimated flux is then:

$\alpha$-$/cm^2$-hr $<0.0004 + 0.0002) = <0.0006$.

To obtain most preferred flux values of $Al(OH)_3$ and $Al_2O_3$, reactant water should have the uranium and thorium values shown in the following computation. Values can exceed those shown provided they do not exceed the threshold for the "ultra low $\alpha$-emitting" characterization.

In the conversion of $AlEt_3$ to alumina by hydrolysis, three water molecules are used for each aluminum ion. Any uranium or thorium present in the water used for hydrolysis is transferred to the alumina produced.

$AlEt_3 + 3H_2O \rightarrow 3C_2H_6 + Al(OH)_3$

$2Al(OH)_3 \rightarrow Al_2O_3 + 3H_2O$

Each part by weight of alumina requires for its synthesis 1.06 parts of water. Using the detection limit established for U in the water supplied for hydrolysis ($<0.046$ ppb) it is found that the water contributes less than 0.05 ppb of uranium to the $Al_2O_3$ product: The water is responsible for an $\alpha$-particle flux in the $Al_2O_3$ made from it of $<2 \times 10^{-5}$ $\alpha$-particles$/cm^2$-hr, as follows: Similarly, the contribution of Th from the water of hydrolysis is $<8 \times 10^{-5}/cm^2$-hr. The total $\alpha$-particle flux in the $Al_2O_3$ from U and Th in the water of hydrolysis is equivalent to $<(2 + 8) \times 10^{-5} < 0.0001/cm^2$-hr.

In fractionation step (i) of this invention, accomplished in a preferred embodiment by distillation, care is taken to avoid entrainment of impurities in the gaseous $Al(Et)_3$. The distillation apparatus can be purged with nitrogen or some early portion of the $Al(Et)_3$ gas fraction. In addition, some portion of the $Al(Et)_3$ can be left as a residue/reservoir for contaminants and not subjected to gasification/condensation. In practice, it has been found convenient, in the distillation embodiment of this invention, to allow the first five percent or so of the distillate to act as a system purge and to leave the last five to ten percent or so of the $Al(Et)_3$ as a reservoir for the contaminants.

The collected distillate of step (ii) will be uncontaminated by $\alpha$-emitting isotopes within the definition provided herein. The distillate is then reacted with water in step (iii) of the process. When the hydrolysis is conducted in the liquid phase, a solvent is often employed to dissipate the heat of reaction, and to disperse the hydroxide. Toluene can be used for this purpose because it may be less likely to become contaminated with metal ion impurities than more polar solvents in which water is soluble. The reaction, and the particle characteristics of the $Al(OH)_3$ resulting from it, can be more readily controlled by use of a more polar solvent in which both reagents for the reaction are soluble. Other solvents that can be employed include benzene, xylene, cyclohexane and the like.

The water that is reacted with the purified $Al(Et)_3$ fraction is carefully prepared to avoid introducing $\alpha$-emitting contaminants into the product. Although there will be several ways to accomplish water preparation, a typical method would likely involve one or more of these steps:

(i) reverse osmosis,

(ii) filtration to remove relatively large particles,

(iii) removal of organic materials by adsorption onto carbon,

(iv) deionization, and

(v) filtration to remove relatively small particles. Purification can be constantly monitored by resistivity, uranium and thorium, and $\alpha$-particle determinations.

For best results, it has been found desirable to take precautions to minimize the exposure of reagents and equipment to contaminants. Equipment can be washed with 50% nitric acid and deionized water. Polymeric fluorocarbon vessels can be used for storage of reagents and solvent, and for the hydrolysis reaction.

## Example 1

### Fractionation and Isolation of Uncontaminated Fraction

Triethylaluminum was distilled in a Pyrex still (Vigreux design, 8 mm i.d. X 17 cm) contained within a nitrogen-purged drybox at a pressure of about 1.5 mm of mercury. The distillate, bp 64° to 67° was collected in fluorocarbon vessel. [CAUTION] Aluminum alkyls should be treated with the care accorded highly pyrophoric and moisture sensitive materials. The still had a theoretical plate count between 2 and 3. Distillation was carefully controlled to avoid entrainment of liquid in the vapor. The middle fraction of about 90% was collected for subsequent hydrolysis.

Hydrolysis Step

Toluene, employed as a non-oxidizing diluent was distilled at atmospheric pressure through a glass column (8 mm i.d., 50 cm) containing a spinning band constructed of poly(tetrafluoroethylene). The toluene-water azeotrope was discarded, and purified toluene was collected and stored in a poly(tetrafluoroethylene) vessel preparatory to use.

The water was purified sequentially as follows: (i) reverse osmosis; (ii) filtration to remove particles larger than 0.5 µm; (iii) removal of organics in a column charged with activated carbon; (iv) deionization using an ion exchange resin; and (v) filtration to remove particles larger than 0.2 µm. The water was found to contain uranium at a level below 0.00005 ppm, thorium at a level below 0.0006 ppm and to have a typical resistivity of about 12 megohm-cm.

A solution of $Al(Et)_3$ in toluene was prepared in a drybox. In a shielded hood, the vessel was connected to a vented bubbler and a source of nitrogen. With nitrogen supplied to maintain a slight positive pressure in the system, the vessel was chilled in an ice bath. With stirring, water as small droplets was added over 2.5 hours. The rate of addition was controlled so that the temperature of the solution remained below the boiling point, and the quantity of ethane did not exceed that easily released through the bubbler. The end of the reaction was signaled by the cessation of the formation of ethane. The suspension was centrifuged, liquids were decanted, and the product was dried under vacuum. Theoretical calculations show $Al(OH)_3$: Al, 34.6; ash, 65.4%. Finding: Al, about 32.3; ash, about 61.6; C, about 1.8%; surface area, about 241 $m^2/g$.

Uranium and thorium analyses were performed by neutron activation procedures. $Al(OH)_3$ made by the method of this invention was found to contain levels of uranium below 0.0007 ppm and thorium below 0.001 ppm.

Example 2

The $Al(OH)_3$ made by the sequential procedure of Example 1 can be converted to $Al_2O_3$ of correspondingly low α-emissions by heating it in an environment which does not contaminate it. For example, the $Al(OH)_3$ is placed in a container which is free of α-particle emitting impurities (or, if such impurities are present, they are bound within the matrix of the container in such a way that they are not able to migrate to the sample) and the container is placed in an environment in which heat can be supplied, such as within an oven. The walls of the furnace are free of α-particle emitting impurities which otherwise could be transferred to the sample, or the sample is otherwise protected from contaminants which could migrate from the walls. Provision is made for the escape of water as the sample is calcined. Upon heating the sample for 15 hrs at 1000°C it is converted to the α-crystalline form of $Al_2O_3$.

Example 3

The $Al_2O_3$ made by the procedure of Example 2 can be converted into a ceramic insulator component of a random access memory device, the component being characterized by α-emissions corresponding to the ultra low values obtained for the $Al_2O_3$ precursor. For example, the ceramic insulator can be made by placing the $Al_2O_3$ powder derived from the described $Al(OH)_3$ in a press of the desired dimensions and supplying heat and pressure until the powder is sintered to full density. The RAM device can be fabricated into an electronics package according to the skill of the art.

Example 4

A sample of 30 ml (25.1 g) of distilled $AlEt_3$ was combined with 0.038 g of $UCl_4$. From this mixture was distilled 28.5 ml of the $AlEt_3$. A portion of the distillate was converted by hydrolysis to $Al(OH)_3$. Had no distillative separation of $AlEt_3$ from $UCl_4$ been achieved, the $Al(OH)_3$ would have contained 1,400,000 ppb of U; found: U <6 ppb.

Example 5

The following techniques can be employed to prepare alumina powders, low in alpha-particle-emitting impurities, doped with magnesium to improve alumina sintering. The quantity of magnesium as magnesium oxide can be about 50 to 1000 parts per million parts of alumina. The purity of the source of the magnesium ion should be such that it does not substantially contaminate the alumina produced by the method of this invention.

The magnesium can be incorporated at any one of several stages in the synthesis of alumina particles. For example, $MgR_2$, where R is an alkyl or alkoxide group or the like, can be mixed with ultra low α-emitting triethylaluminum, and the mixture hydrolyzed. The resulting magnesium ion-doped aluminum hydroxide is then calcined to form magnesia-doped alumina particles. Alternatively, the triethylaluminum can be hydrolyzed by water in which an appropriate magnesium salt is dissolved, and the resulting magnesium ion-doped aluminum hydroxide calcined to produce doped alumina. Alternatively, a solution of a magnesium salt such as the nitrate or magnesium oxide in particulate form can be combined with the aluminum hydroxide, and the mixture calcined; or, magnesium ion in solution or as magnesium oxide can be combined with the alumina formed by calcination of the ultra low α-emitting aluminum hydroxide. Doped alumina, made as described in this Example, can be used according to the skill of the art for fabricating substrates for electronic devices.

## Claims

1. Aluminum hydroxide characterized in that $Al_2O_3$ made from it has an α-radiation flux below about 0.003/cm²-hr.

2. Aluminum hydroxide as claimed in claim 1 characterized in that $Al_2O_3$ made from it has an α-radiation flux below 0.001/cm²-hr.

3. Aluminum hydroxide as claimed in claim 1 or claim 2 characterized further by a uranium level below 0.0007 ppm and a thorium level below 0.001 ppm.

4. Aluminum hydroxide as claimed in claim 2 characterized in that $Al_2O_3$ made from it has an α-radiation flux not exceeding about 0.0006/cm²-hr.

5. Aluminum hydroxide as claimed in claim 4 characterized further in that $Al_2O_3$ made from it has a uranium level below 0.001 ppm and a thorium level below 0.0015 ppm.

6. $Al_2O_3$ characterized by an α-radiation flux below about 0.003/cm²-hr.

7. $Al_2O_3$ as claimed in claim 6 characterized by an α-radiation flux and/or a uranium level and a thorium level as defined in any of claims 2 to 5.

8. An electronics package having a ceramic insulating substrate, said substrate comprising $Al_2O_3$ as claimed in claim 6 or claim 7.

9. A random access memory component including an electronics package as claimed in claim 8.

10. A computer having a random access memory component as claimed in claim 9.

11. A method of making integrated circuit random access memory components comprising mounting the integrated circuitry in contact with a ceramic insulator comprising $Al_2O_3$ as claimed in claim 6 or claim 7.

12. A method of making aluminum hydroxide as claimed in any of claims 1 to 5 comprising hydrolyzing triethylaluminum having an ultra low α-radiation flux by contacting it with water having an ultra low α-radiation flux.

13. A method of making aluminum hydroxide as claimed in any of claims 1 to 5 comprising the steps of:

(i) fractionating substantially unhydrolyzed triethylaluminum contaminated by α-radiation-emitting contaminants into a fraction consisting essentially of ultra low α-emitting triethylaluminum and a fraction comprising substantially all the α-emitting contaminants;

(ii) separating the uncontaminated triethylaluminum from the contaminants; and

(iii) hydrolyzing the uncontaminated triethylaluminum by contacting it with ultra low α-emitting water.

14. $Al_2O_3$ as claimed in claim 6 or claim 7 in combination with a dopant.

European Patent Office

# EUROPEAN SEARCH REPORT

Application Number

EP 88 30 4865

## DOCUMENTS CONSIDERED TO BE RELEVANT

| Category | Citation of document with indication, where appropriate, of relevant passages | Relevant to claim | CLASSIFICATION OF THE APPLICATION (Int. Cl.4) |
|---|---|---|---|
| A | CHEMICAL ABSTRACTS, vol. 100, no. 26, June 1984, page 139, no. 212453h, Columbus, Ohio, US; & JP-A-59 30 719 (SUMITOMO CHEMICAL CO., LTD) 18-02-1984 --- | | C 01 F 7/46<br>C 01 F 7/36<br>H 01 L 23/14 |
| A | EP-A-0 116 319 (SUMITOMO CHEMICAL CO.)<br>* Pages 11,12, example 1; page 24, claim 10 * --- | 3,5,12 | |
| A | CHEMICAL ABSTRACTS, vol. 104, no. 20, May 1986, page 133, no. 170856s, Columbus, Ohio, US; C. SATO et al.: "Behavior of radioactive elements (uranium and thorium) in Bayer process" & LIGHT MET. (WARRENDALE, PA.) 1986, 2, 11-17<br>* Abstract * --- | 1,8 | |
| A | CHEMICAL ABSTRACTS, vol. 96, no. 18, 3rd May 1982, page 158, no. 145403a, Columbus, Ohio, US; & JP-A-82 03 715 (SHOWA KEIKINZOKU K.K.) 09-01-1982<br>* Abstract * --- | 9 | **TECHNICAL FIELDS SEARCHED (Int. Cl.4)** |
| A | CHEMICAL ABSTRACTS, vol. 76, no. 21, 22nd May 1972, page 504, no. 127058z, Columbus, Ohio, US; E.P. BEZUKH et al.: "Separation and purification of organoaluminum compounds" & KHIM. PROM. (MOSCOW) 1972, 48(2), 87-9<br>* Abstract * --- | 13 | C 01 F<br>H 01 L |
| A | FR-A-2 253 711 (SUMITOMO CHEMICAL CO., LTD)<br>* Page 1, lines 8-11 * ----- | 13 | |

The present search report has been drawn up for all claims

| Place of search | Date of completion of the search | Examiner |
|---|---|---|
| THE HAGUE | 12-09-1988 | LIBBERECHT-VERBEECK E.M. |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document